Europäisches Patentamt

European Patent Office

Office européen des brevets

(11) Numéro de publication: **0 351 291**
**A1**

## DEMANDE DE BREVET EUROPEEN

(21) Numéro de dépôt: **89401941.3**

(22) Date de dépôt: **06.07.89**

(51) Int. Cl.5: **G 01 R 15/00**

(30) Priorité: **13.07.88 FR 8809557**

(43) Date de publication de la demande:
**17.01.90 Bulletin 90/03**

(84) Etats contractants désignés:
**AT BE CH DE ES GB GR IT LI LU NL SE**

(71) Demandeur: **RADIO CONTROLE S.A.**
**13, rue Clément Boyer**
**F-69000 Lyon (Rhone) (FR)**

(72) Inventeur: **Palencher, Jacques**
**26 rue Général Saussier**
**Troyes (Aube) (FR)**

**Boeglin, Jean-Pierre**
**30 rue Thieblemont**
**La Chapelle Saint Luc (Aube) (FR)**

(74) Mandataire: **Cabinet Pierre HERRBURGER**
**115, Boulevard Haussmann**
**F-75008 Paris (FR)**

(54) **Appareil de mesure d'une grandeur électrique.**

(57) Appareil de mesure d'une grandeur électrique, se composant d'un boîtier (1) pourvu d'un moyen (2) pour l'affichage de la valeur d'au moins un paramètre à mesurer d'une grandeur électrique, de bornes d'entrée (6₁) sur lesquelles la grandeur électrique à mesurer est amenée, un microprocesseur relié, à l'intérieur du boîtier, aux bornes d'entrée et au moyen d'affichage pour le traitement de cette grandeur électrique et l'actionnement du moyen d'affichage par un signal fonction de la valeur mesurée, appareil de mesure caractérisé en ce que ce boîtier comporte également une mémoire morte constituée par un composant indépendant du microprocesseur et contenant le ou les programmes de calcul du microprocesseur pour le traitement de la grandeur électrique et la délivrance, par ce microprocesseur, vers le moyen d'affichage, d'un signal fonction de la valeur du paramètre mesuré.

FIG.1

EP 0 351 291 A1

# Description

## Appareil de mesure d'une grandeur électrique.

L'invention concerne un appareil de mesure d'une grandeur électrique.

On connaît déjà des appareils de mesure d'une grandeur électrique qui comprennent, à l'intérieur d'un boîtier, un microprocesseur constituant l'unité de traitement d'une grandeur électrique à mesurer, cette grandeur étant amenée sur des bornes d'entrée et la valeur mesurée, issue du microprocesseur, étant amenée sur un moyen d'affichage.

Ces appareils présentent cependant deux inconvénients majeurs, d'une part ils sont d'un prix de revient relativement élevé, d'autre part, le programme de calcul du microprocesseur est figé de manière définitive et il ne peut donc pas être mis en oeuvre par une adaptation simple à la mesure de grandeurs électriques diverses.

La présente invention a notamment pour but de remédier à ces inconvénients et concerne à cet effet un appareil de mesure d'une grandeur électrique, se composant d'un boîtier pourvu d'un moyen pour l'affichage de la valeur d'au moins un paramètre à mesurer d'une grandeur électrique, de bornes d'entrée sur lesquelles la grandeur électrique à mesurer est amenée, un microprocesseur relié, à l'intérieur du boîtier, aux bornes d'entrée et au moyen d'affichage pour le traitement de cette grandeur électrique et l'actionnement du moyen d'affichage par un signal fonction de la valeur mesurée, appareil de mesure caractérisé en ce que ce boîtier comporte également une mémoire morte constituée par un composant indépendant du microprocesseur et contenant le ou les programmes de calcul du microprocesseur pour le traitement de la grandeur électrique et la délivrance, par ce microprocesseur, vers le moyen d'affichage, d'un signal fonction de la valeur du paramètre mesuré.

Suivant une autre caractéristique de l'invention, le boîtier comporte un clavier relié au microprocesseur pour la sélection des paramètres de la mesure.

Suivant une autre caractéristique de l'invention, le boîtier comporte une fente pour l'introduction d'une carte mémoire et sa liaison, à l'intérieur du boîtier, à un connecteur relié au microprocesseur.

L'invention est représentée à titre d'exemple non limitatif sur les dessins ci-joints dans lesquels :
- la figure 1 est une vue en perspective d'un appareil de mesure conforme à l'invention,
- la figure 2 est un schéma synoptique de l'appareil de la figure 1.

L'appareil représenté sur les dessins ci-joints comprend un boîtier 1 sur la face avant duquel est prévu un moyen d'affichage numérique ou analogique 2, un clavier 3 pour l'introduction des paramètres de mesure, une fente 4 pour l'introduction d'une carte mémoire 5. Par ailleurs, ce boîtier comporte une barrette à bornes 6 dont les bornes $6_1$ sont destinées à être reliées à la grandeur électrique dont on désire mesurer l'une ou plusieurs des valeurs caractéristi ques.

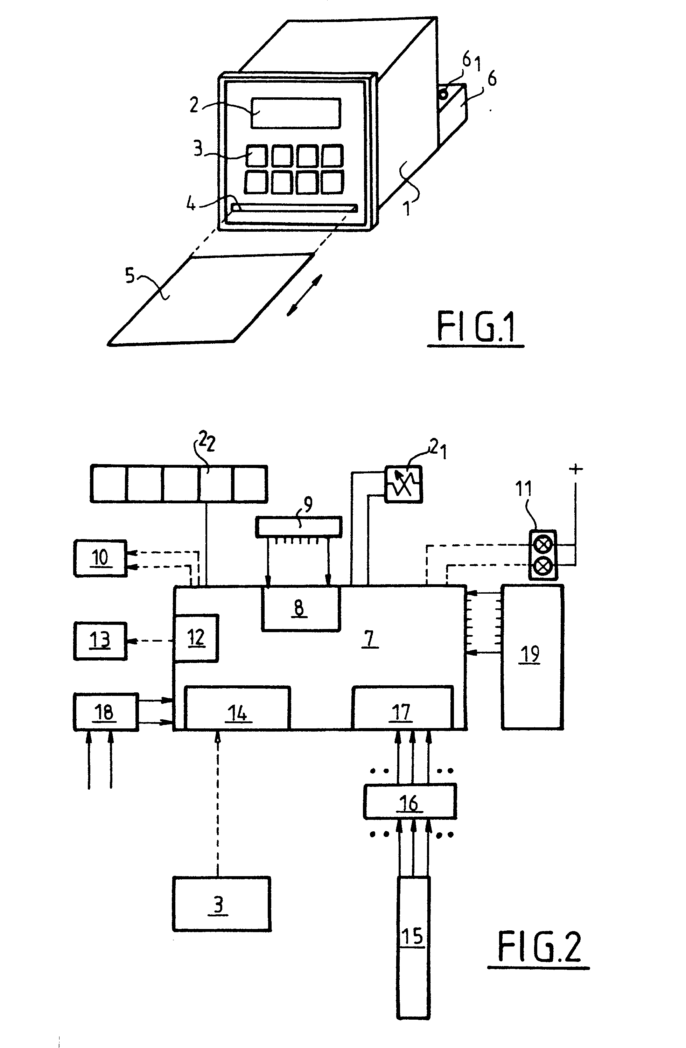

A l'intérieur de ce boîtier est prévue une unité de traitement 7 (voir figure 2), comprenant un microprocesseur schématisé en 8, cette unité de traitement étant reliée au moyen d'affichage 2 qui est constitué, soit par un appareil d'affichage à aiguille $2_1$, soit par un appareil d'affichage numérique $2_1$ à diode électro-luminescente ou alphanumérique $2_2$. Le microprocesseur 8 est relié à un connecteur 9 dans lequel s'insère l'extrémité de la carte-mémoire 5 introduite dans la fente 4 et cela afin que cette carte-mémoire puisse enregistrer toutes les informations souhaitables transitant dans le microprocesseur 8 et cela pour une période de temps déterminée. Cette carte pourra ensuite être lue afin de contrôler les diverses valeurs enregistrées et leurs évolutions en fonction du temps.

L'unité de traitement 7 peut également être reliée à divers dispositifs accessoires contenus ou non dans le boîtier 1 et constitués, par exemple, par un moyen d'alarme 10 destiné a signaler immédiatement qu'une valeur déterminée de la grandeur mesurée est atteinte, ou encore par des voyants 11 signalant que l'un des paramètres considérés de la grandeur mesurée a atteint une valeur de seul determinée.

L'appareil conforme à l'invention pourra également être pourvu, dans l'unité de traitement 7, d'un étage 12 assurant la liaison de l'unité de traitement avec un réseau extérieur 13 en vue de l'utilisation des informations résultant des mesures pour effectuer une commande quelconque et, par exemple, la commande du fonctionnement d'une installation ou la correction de son fonctionnement.

Le clavier 3 est destiné à permettre l'entrée des paramètres des diverses mesures que l'on désire effectuer. Ainsi ce clavier permettra, par exemple par l'intermédiaire de l'étage schématisé en 14, le choix des diverses fonctions devant être effectuées par l'appareil, la mise à l'échelle désirée des moyens d'affichage 2, la détermination du niveau de déclenchement des alarmes 10, la programmation de l'heure, la commande de l'affichage successif dans un ordre déterminé, des paramètres des grandeurs électriques à mesurer amenées sur les bornes d'entrée $6_1$, etc.

Dans le cas où cet appareil doit être destiné à la mesure de grandeurs physiques quelconques, il sera nécessaire de mettre en oeuvre une carte de conversion 15 assurant la traduction de la grandeur physique à mesurer en une grandeur électrique par l'intermédiaire de l'étage 16 et par le convertisseur analogique-digital 17.

Le fonctionnement de cet appareil de mesure est assuré à partir d'une source d'énergie électrique et par l'intermédiaire d'une alimentation 18 délivrant la tension continue nécessaire au fonctionnement des composants de l'appareil.

Conformément à l'invention, le programme de calcul du microprocesseur est inclus dans une mémoire morte 19 qui constitue un composant indépendant du microprocesseur 8, que celui-ci comporte ou non déjà une mémoire morte. Le programme de calcul inclus dans la mémoire morte 19 permet au microprocesseur de traiter la grandeur électrique dont on désire mesurer l'un des paramètres afin que ce microprocesseur délivre à l'un ou l'autre des moyens d'affichage $2_1$, $2_2$ un signal fonction de la valeur analogique du paramètre mesuré.

Egalement, la carte-mémoire, le connecteur, le microprocesseur et la mémoire morte pourront être conçus, non seulement pour réaliser, sur la carte-mémoire, l'enregistrement des informations issues du microprocesseur et relatives aux mesurer effectuées, mais aussi pour commander le microprocesseur à partir d'informations de la carte mémoire pour l'exécution de certaines mesures et leur traitement et pour leur ordonnancement, ces mesures étant soit affichées sur l'appareil, soit enregistrées sur la carte.

Ainsi, l'appareil de mesure conforme à l'invention peut être adapté rapidement et à peu de frais en fonction des paramètres que l'on désire mesurer, simplement en mettant en oeuvre une mémoire morte 19 qui est programmée à la fabrication pour une ou plusieurs applications déterminées. Dans chaque cas, l'échelle de mesure pourra être réglée par le clavier, ou par la carte mémoire, tandis que l'une ou plusieurs des bornes $6_1$ affectées chacune à une grandeur à mesurer, seront utilisées.

**Revendications**

1) Appareil de mesure d'une grandeur électrique, se composant d'un boîtier (1) pourvu d'un moyen (2) pour l'affichage de la valeur d'au moins un paramètre à mesurer d'une grandeur électrique, de bornes d'entrée ($6_1$) sur lesquelles la grandeur électrique à mesurer est amenée, un microprocesseur (8) relié, à l'intérieur du boîtier, aux bornes d'entrée et au moyen d'affichage pour le traitement de cette grandeur électrique et l'actionnement du moyen d'affichage par un signal fonction de la valeur mesurée, appareil de mesure caractérisé en ce que ce boîtier comporte également une mémoire constituée par un composant indépendant du microprocesseur et contenant le ou les programmes de calcul du microprocesseur pour le traitement de la grandeur électrique et la délivrance, par ce microprocesseur, vers le moyen d'affichage, d'un signal fonction de la valeur du paramètre mesuré.

2) Appareil conforme à la revendication 1, caractérisé en ce que le boîtier (1) comporte un clavier (3) relié au microprocesseur pour la sélection des paramètres de la mesure.

3) Appareil conforme à la revendication 1, caractérisé en ce que le boîtier comporte une fente (4) pour l'introduction d'une carte-mémoire (5) et sa liaison, à l'intérieur du boîtier, à un connecteur (9) relié au microprocesseur (8) pour l'enregistrement d'informations issues du microprocesseur et relatives aux mesures effectuées.

4) Appareil conforme à la revendication 3, caractérisé en ce que la carte-mémoire (5), le connecteur (9), le microprocesseur (8) et la mémoire morte (19), sont réalisés et reliés afin d'enregistrer sur la carte-mémoire des informations issues du micropro cesseur et relatives notamment aux mesures effectuées.

5) Appareil conforme à l'une quelconque des revendications 3 ou 4, caractérisé en ce que la carte mémoire, le connecteur et le microprocesseur sont réalisés et reliés afin de commander le microprocesseur à partir d'informations de la carte-mémoire pour l'exécution de mesures et leur traitement et/ou leur ordonnancement.

6) Appareil conforme à l'une quelconque des revendications précédentes, caractérisé en ce qu'il comporte plusieurs bornes d'entrée ($6_1$) affectées chacune à une grandeur à mesurer.

FIG.1

FIG.2

Office européen des brevets

**RAPPORT DE RECHERCHE EUROPEENNE**

Numero de la demande

EP 89 40 1941

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | J.E.E. - JOURNAL OF ELECTRONIC ENGINEERING, vol. 22, no. 218, février 1985, pages 70-75, Tokyo, JP; M. SANAGI et al.: "Analyzing recorder puts diagnostic power in compact, microprocessor-aided package" * En entier * | 1-6 | G 01 R 15/00 |
| X | DE-A-3 511 602 (CREATEC) * Page 11, lignes 13-21; page 18, lignes 16-17; page 30, lignes 5-28; revendications 1,2,4-7,11,14; résumé; figures 1,3 * | 1-3,5,6 | |
| X | ELECTRONIQUE APPLICATIONS, vol. 1597, no. 17, avril-mai 1981, pages 81-90, Paris, FR; J.-C. BAUD: "Applications avec 14 programmes mathématiques et une mémorisation des mesures dans un multimètre de haute précision à microprocesseur" * Page 82, colonne de gauche, premier paragraphe; page 81, figure * | 1,2,6 | |
| A | IDEM | 3-5 | **DOMAINES TECHNIQUES RECHERCHES (Int. Cl.5)** G 01 R G 01 D |
| X | US-A-4 418 392 (HATA) * Revendications 1,2; résumé; figure 4 * | 1,6 | |
| A | | 3,5 | |

Le présent rapport a été établi pour toutes les revendications

| Lieu de la recherche | Date d'achèvement de la recherche | Examinateur |
|---|---|---|
| LA HAYE | 29-09-1989 | HOORNAERT W. |